# EUROPEAN PATENT SPECIFICATION

(11) **EP 3 474 572 B1**
(45) Date of publication and mention of the grant of the patent: **03.08.2022**
(21) Application number: 18200895.3
(22) Date of filing: 17.10.2018
(51) Int. Cl.: G10K 9/12, G10K 9/122, G10K 9/13, H04R 7/14, H04R 17/00, H04R 19/00, H04R 19/02

(54) **AIR PULSE GENERATING ELEMENT AND MANUFACTURING METHOD THEREOF**
LUFTIMPULSERZEUGENDES ELEMENT UND HERSTELLUNGSVERFAHREN DAFÜR
ÉLÉMENT DE GÉNÉRATION D'IMPULSION D'AIR ET SON PROCÉDÉ DE FABRICATION

(30) Priority: 18.10.2017 US 201762574089 P; 05.04.2018 US 201862652908 P; 19.08.2018 US 201862719694 P; 23.08.2018 US 201862722085 P; 16.10.2018 US 201816161097
(43) Date of publication of application: 24.04.2019
(73) Proprietor: xMEMS Labs, Inc., Santa Clara, CA 95051 (US)
(72) Inventor: Liang, Jemm Yue, Sunnyvale, CA 94086 (US); Lo, Chiung C., San Jose, CA 95124 (US); Chen, Wen-Chien, 232 New Taipei City (TW); Chang, Chun-I, 310 Hsinchu County (TW)
(74) Representative: Straus, Alexander

(56) References cited:
- WO-A2-2016/202790
- US-A1- 2003 215 972
- US-A1- 2009 124 035
- US-A1- 2011 140 216
- NEUMANN J J ET AL: "CMOS-MEMS membrane for audio-frequency acoustic actuation", SENSORS AND ACTUATORS A: PHYS, ELSEVIER BV, NL, vol. 95, no. 2-3, 1 January 2002 (2002-01-01), pages 175-182, XP004377889, ISSN: 0924-4247, DOI: 10.1016/S0924-4247(01)00728-2

## Description

### Field of the Invention

The present invention relates to an air pulse generating element and manufacturing method thereof, and more particularly, to an air pulse generating element and manufacturing method capable of producing high fidelity sound.

### Background of the Invention

Speaker driver is always the most difficult challenge for high-fidelity sound reproduction in the speaker industry. The physics of sound wave propagation teaches that, within the human audible frequency range, the sound pressures generated by accelerating a membrane of a conventional speaker driver may be expressed as P ∝ S · A (eq-1), where S is the membrane surface area and A is the acceleration of the membrane. Namely, the sound pressure P is proportional to the product of the membrane surface area S and the acceleration of the membrane A. In addition, the membrane displacement D may be expressed as D ∝ 1/2 · A · T² ∝ 1 /*f*² (eq-2), where T and f are the period and the frequency of the sound wave respectively. The air volume movement V_{A,CV} caused by the conventional speaker driver may then be expressed as V_{A,CV} ∝ S·D. For a specific speaker driver, where the membrane surface area is constant, the air movement V_{A,CV} is proportional to 1/f², i.e., V_{A,CV} ∝ 1/f² (eq-3).

In order to produce enough sound pressure P of the speaker driver, either the acceleration of the membrane A or the membrane displacement D of the speaker driver should be increased. However, the membrane displacement D of the conventional speaker driver is restricted to a peak displacement of the membrane, which confines the sound pressure P of the conventional speaker driver.

Therefore, how to provide an air pulse generating element to overcome the design challenges faced by conventional speakers as stated above is an important objective in the field.

World Intellectual Property Organization application No. WO 2016/202790 A2 provides a MEMS transducer for interacting with a volume flow of a fluid, which comprises a cavity and an electromechanical transducer, wherein the electromechanical transducer can be deformed along a lateral movement direction and the volume flow of the fluid are causally related. U.S. application No. US 2009/0124035 A1 provides a micro-fluidic system achieved by using a multi-wafer fabrication procedure, which utilizes only dry etch processes to form micro-chambers, and particularly, deep reactive ion etching whereby multiple trenches of differing depths may be formed simultaneously.

### Summary of the Invention

It is therefore a primary objective of the present application to provide air pulse generating element and manufacturing method capable of producing high fidelity sound and enough sound pressure.

This is achieved by an air pulse generating element according to the independent claim 1 or by manufacturing methods according to the independent claims 13, 16 here below. The dependent claims pertain to corresponding further developments and improvements.

As will be seen more clearly from the detailed description following below, the present application discloses an air pulse generating element according to claim 1.

In an embodiment, the first front valve is controlled by a first front valve-controlling signal to control an airflow through the back faceplate; the first back valve, controlled by a first back valve-controlling signal to control the airflow through the back faceplate; the second front valve, controlled by a second front valve-controlling signal to control the airflow through the front faceplate; and the second back valve, controlled by a second back valve-controlling signal to control the airflow through the back faceplate.

In an embodiment, the first front valve-controlling signal equals the second back valve-controlling signal, and the first back valve-controlling signal equals the second front valve-controlling signal.

In an embodiment, the plurality of actuators are electrostatic actuators with a plurality of electrodes, such that the plurality of membrane units perform the horizontal deformation when a plurality of driving charges are applied on the plurality of electrodes.

In an embodiment, when the plurality of actuators are piezoelectric actuators with a plurality of electrodes, the plurality of membrane units perform the horizontal deformation when a plurality of driving charges are applied on the plurality of electrodes.

In an embodiment, when the folded membrane is incorporated with electromagnetic actuator and a current flows along the folded membrane, the plurality of membrane units perform the horizontal deformation.

In an embodiment, the air pulse generating element is configured to receive an input audio signal, and an amplitude and a polarity of each air pulse generated by the air pulse generating element are related to a amplitude and a polarity of a time-sample of the input audio signal.

In an embodiment, a driving voltage is applied to each of a plurality of actuators of the air pulse generating element, such that the air pulse generating element generates a plurality of air pulses in response to the driving voltage; a plurality of air pulses are at a pulse rate, and the pulse rate of the plurality of air pulses is higher than a maximum audible frequency.

In an embodiment, the pulse rate of the plurality of air pulses is at least twice higher than a maximum frequency of an input audio signal to be reproduced.

In an embodiment, the pulse rate of the plurality of air pulses is at least twice higher than a maximum audible frequency.

In an embodiment, a direction of an air mass velocity within a pulse cycle is in a front-to-back direction or a back-to-front direction regardless an initial position of the folded membrane, and a plurality of valve-controlling signals are generated to the plurality of valves to perform an open-and-close movement.

In an embodiment, the horizontal deformation performed by the plurality of membrane units and the open-and-close movement performed by the plurality of valves are mutually synchronized.

Another embodiment of the present application discloses a manufacturing method for the folded membrane of the air pulse generating element of claim 1, comprising depositing a substrate; performing a reactive-ion etching (RIE) or a deep reactive-ion etching (DRIE) on the substrate with a folded pattern; depositing a first dielectric layer on the substrate; depositing a conductive layer on the first dielectric layer; depositing a second dielectric layer on the conductive layer; and etching the substrate to form the folded membrane.

Another embodiment of the present application discloses a manufacturing method for the folded membrane of the air pulse generating element of claim 1, comprising forming a plurality of trenches on a patterned substrate; performing an isotropic etching to undercut a bottom of the plurality of trenches and forming a plurality of connection units; coating the plurality of trenches with a polymer film; and removing the patterned substrate to form the folded membrane.

### Brief Description of the Drawings

FIG. 1 is a schematic diagram of a cross-sectional view of an air pulse generating element according to an embodiment of the present application.
FIG. 2 is a schematic diagram of a folded membrane according to an embodiment of the present application.
FIG. 3 is a schematic diagram of a cross-sectional view of an actuator according to an embodiment of the present application.
FIG. 4 is a schematic diagram of the actuators with piezoelectric electrode formed on the folded membrane according to an embodiment of the present application.
FIG. 5 is a schematic diagram of the actuators with the piezoelectric electrodes formed on the folded membrane according to another embodiment of the present application.
FIG. 6 is a schematic diagram of air-out phase when 1-layer piezoelectric actuators are formed on the folded membrane according to an embodiment of the present application.
FIG. 7 is a schematic diagram of air-in phase when 1-layer piezoelectric actuators are formed on the folded membrane according to an embodiment of the present application.
FIG. 8 is a schematic diagram of air-out phase when 2-layer piezoelectric actuators are formed on the folded membrane according to an embodiment of the present application.
FIG. 9 is a schematic diagram of air-in phase when 2-layer piezoelectric actuators are formed on the folded membrane according to an embodiment of the present application.
FIG. 10 is a schematic diagram of an air mass velocity according to an embodiment of the present application.
FIG. 11 is a schematic diagram of an air mass velocity according to an embodiment of the present application.
FIG. 12 is a schematic diagram of a sound pressure level (SPL) according to an embodiment of the present application.
FIG. 13 is a schematic diagram of the SPL according to an embodiment of the present application.
FIG. 14 is a schematic diagram of the air pulse generating elements according to an embodiment of the present application.
FIG. 15 is a schematic diagram of a cross-sectional view of an air pulse generating element according to another embodiment of the present application.
FIG. 16 is a cross-sectional view of an air pulse generating element according to another embodiment of the present application.
FIG. 17 is a schematic diagram of a manufacturing process for manufacturing the folded membrane of the air pulse generating element according to an embodiment of the present application.
FIG. 18 is a structural diagram corresponding to the manufacturing process in FIG. 17.
FIG. 19 is a schematic diagram of a manufacturing process for manufacturing the folded membrane with piezoelectric actuators of air pulse generating element according to an embodiment of the present application.
FIG. 20 is a structural diagram corresponding to the manufacturing process in FIG. 19.
FIG. 21 is a schematic diagram of a manufacturing process for manufacturing the folded membrane of the air pulse generating element according to an embodiment of the present application.
FIGs. 22 and 23 are structural diagrams corresponding to the manufacturing process in FIG. 20.

### Detailed Description

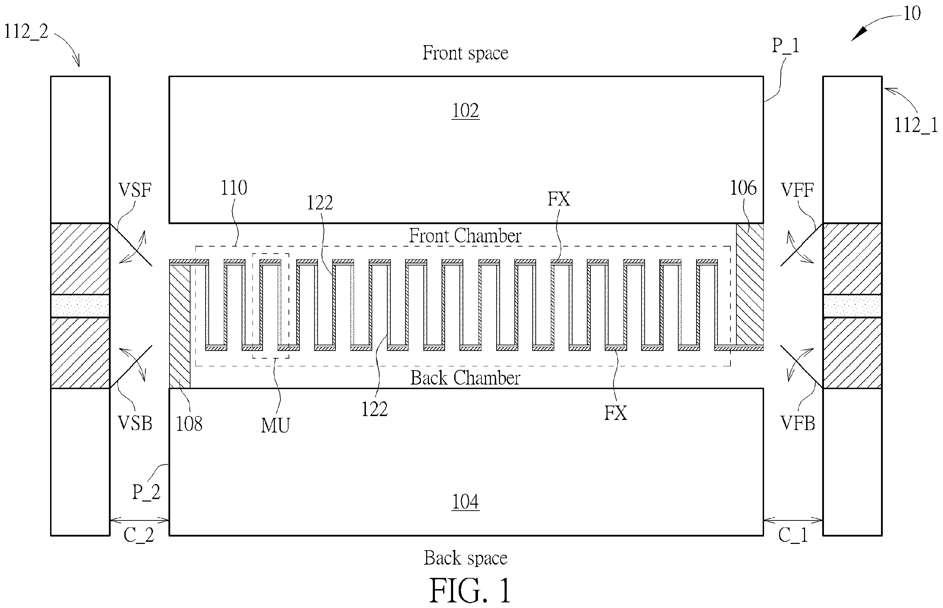

Please refer to FIG. 1, which is a schematic diagram of a cross-sectional view of an air pulse generating element 10 according to an embodiment of the present application. The air pulse generating element 10 may be a MEMS (micro-electrical-mechanical-system) device, which includes a front faceplate 102, a back faceplate 104, a front supporting element 106, a back supporting element 108, a folded membrane 110, a first wall 112_1, a second wall 112_2, a first front valve VFF, a first back valve VFB, a second front valve VSF and a second back valve VSB. The folded membrane 110 is a thin membrane made of single crystal Silicon, poly-silicon, Mylar, dry film, Benzocyclobutene(BCB), Parylene(Poly-p-xylene) for non-conductive type polymer; Polydimethylsiloxane(PDMS), Poly-3,4-Ethylenedioxythiophene (PEDOT), polyaniline(PANI), Polythiophenes(PTs), poly(p-phenylene sulfide)(PPS), poly(p-phenylene vinylene)(PPV) and Poly(acetylene)(PAC) for conductive type polymer. The folded membrane 110 is configured to form a front chamber and a back chamber with the front faceplate 102 and the back faceplate 104, and consisted of a plurality of membrane units MU. The membrane units MU are parallel and sequentially connected. In addition, an end of the folded membrane 110 is connected to the back faceplate 104 via the back supporting element 108 and another end of the folded membrane 110 is connected to the front faceplate 102 via the front supporting element 106. The first wall 112_1 is disposed along a first plane P_1 corresponding to a side of the front supporting element 106 with a first channel C_1, the first front valve VFF and the first back valve VFB are connected to the front or back space at the first wall 112_1 and extended from the first wall 112_1 toward the front supporting element 106. On the opposite side of the front supporting element 106, the second wall 112_2 is disposed along a second plane P_2 corresponding to a side of the back supporting element 108 with a second channel C_2, and the second front valve VSF and the second back valve VSB are connected to the front or back space at the second wall 112_2 and extended from the second wall 112_2 toward the back supporting element 108.

In the embodiment illustrated in FIG. 1, the membrane units MU are mounted on a plurality of fixing elements FX, such that the membrane units MU may flexibly perform the horizontal deformation. More specifically, the fixing elements FX fix the folded membrane 110 at both ends of each of the membrane units MU, such that each the membrane units MU may perform the horizontal deformation driven by actuators 122 deposited on the membrane units MU. The horizontal deformation of membrane units MU increase or decrease the pressure at front or back chamber, respectively. The pressure change causes air movement of squeeze out or suck from these chambers into front or back space through the open and close movement of valves. Specifically, the top surface of the membrane units MU of the folded membrane 110 is connected to front chamber. If it is configured to perform a horizontal deformation to reduce the volume of the front chamber, air movement will flow toward the front space if the second front valve VSF is opened and the second back valve VSB is closed or toward the back space if the second front valve VSF is closed and the second back valve VSB is opened. At the moment, the horizontal deformation of the folded membrane 110 increases the volume of the back chamber, and cause sucking in air from the front space if the first front valve VFF is opened and the first back valve VFB is closed, or from the back space if the first front valve VFF is closed and the first back valve VFB is opened. The horizontal deformation of the folded membrane 110 is designed to increase or decrease the volume of front or back chamber and is controlled by a membrane-controlling signal which is connected to the actuators 122 of the folded membrane 110, such that air in the front chamber and back chamber of the air pulse generating element 10 is squeezed in and out to produce a sound pressure level.

In addition, the first front valve VFF is controlled by a first front valve-controlling signal to control an airflow through the front faceplate 102, the first back valve VFB is controlled by a first back valve-controlling signal to control the airflow through the back faceplate 104, the second front valve VSF is controlled by a second front valve-controlling signal to control the airflow through the front faceplate 102, and the second back valve VSB is controlled by a second back valve-controlling signal to control the airflow through the back faceplate 104.

Regarding operations of the valves VFF, VFB, VSF and VSB, the first front valve-controlling signal might be equal to the second back valve-controlling signal, and the first back valve-controlling signal might be equals to the second front valve-controlling signal. In other words, the first front and second back valve-controlling signals respectively control the first front valve VFF and the second back valve VSB to open or close at the same time for some embodiments, and the first back and second front valve-controlling signals respectively control the first back valve VFF and the second front valve VSB to open or close at the same time for some embodiments. In this way, the valves VFF, VFB, VSF and VSB are controlled to open and close to enable the horizontal deformation of the membrane units MU, squeeze the air into the front chamber or back chamber of the air pulse generating element 10 and produce the sound pressure level. Therefore, the horizontal deformation performed by the membrane units MU and the open-and-close movement performed by the valves are mutually synchronized.

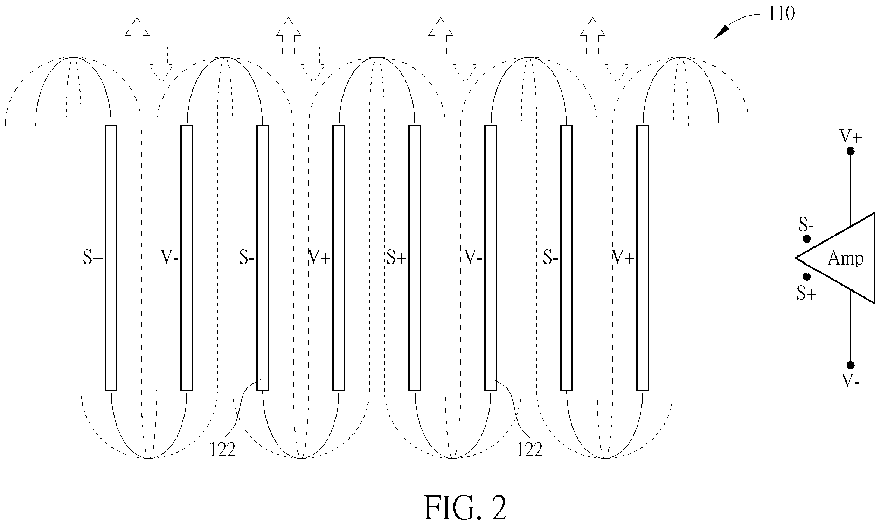

The air pulse generating element 10 further comprises a plurality of actuators 122 on each of the membrane units MU. As can be seen in FIG. 2, the actuators 122 are respectively formed on or attached to both sides of the membrane units MU. In an embodiment, when the actuators 122 are electrostatic actuator with flat electrodes and electrically conducted, the membrane units MU may perform the horizontal deformation with a plurality of driving charges applied on the electrodes. For example, the electrodes may be attached or formed on an underlying flexible film by printing or depositing stripes of conductive patterns on a Mylar film. In an embodiment, the electrodes may be respectively connected to a power amplifier, which provides voltages V+, V- and bias signals S+, S-, wherein the voltages V+, V- may be bias voltages for the power amplifier and the bias signals S+, S- may be differential output signals of the power amplifier.

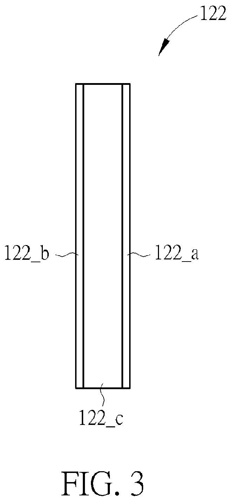

Please refer to FIG. 3, which is a schematic diagram of a cross-sectional view of the actuator 122 according to an embodiment of the piezoelectric actuators. The actuator 122 may comprise a piezoelectric layer 122_c sandwiched between two electrodes 122_a and 122_b. The bias signals S+ or S- may be applied on the electrode 122_a and the electrode 122_b. The piezoelectric layer 122_c may, but not limited to, be made of PZT (lead zirconate titanate) or AIScN (scandium doped aluminum nitride). The electrodes 122_a is made of platinum (Pt) for some embodiments, deposited onto a side facing the membrane unit MU and served as the bias electrode, and the electrodes 122_c is made of gold (Au) for some embodiments, deposited onto a side facing the air and served as the driving electrode.

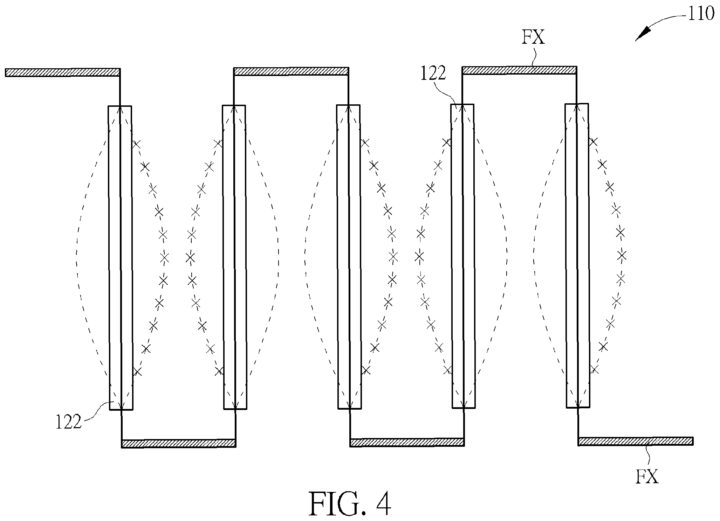

In an embodiment, please refer to FIG. 4, which is a schematic diagram of the actuators 112 with piezoelectric films and electrodes formed on the vertical sidewall of folded membrane 110 according to an embodiment of the present application. In the embodiment, the membrane units MU may bend to two directions so as to perform the horizontal deformation. More specifically, when all bias electrodes (i.e. electrode 122_a of each of the membrane units MU) are connected to Vbias, a connection order for the driving electrodes corresponding to the membrane units MU respectively in FIG. 4 is [S-, S+], [S+, S-], [S-, S+], [S+, S-]... Dot lines and cross lines in FIG. 4 illustrate positions of the membrane units MU when the dual polarity driving signals S+ and S- reach the peak and valley of the driving signal, which correspond to a peak displacement of the membrane units MU. Therefore, with the displacement of the membrane units MU, the air will be moved in and out of the front chamber and the back chamber, and thus produce sound pressure level and sound wave. Notably, the connection order for the driving electrodes corresponding to the membrane units MU respectively in FIG. 4 may also be [S+, S-], [S-, S+], [S+, S-], [S-, S+]...

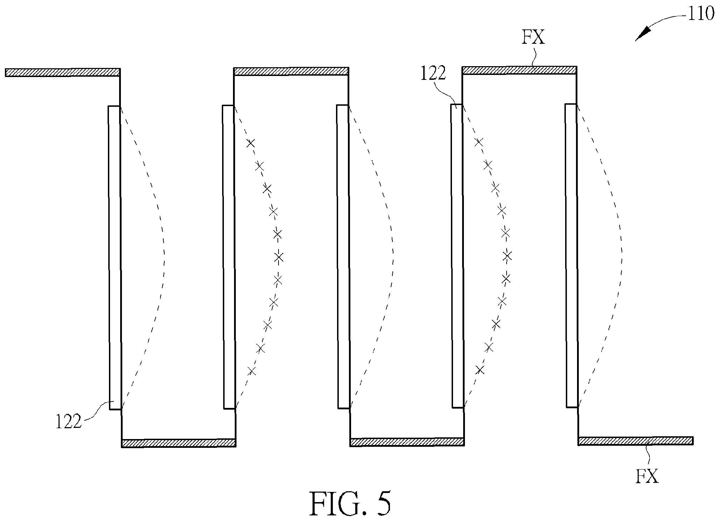

In another embodiment, please refer to FIG. 5, which is a schematic diagram of the actuators 122 with the piezoelectric electrodes formed on the folded membrane 110 according to another embodiment of the present application. In FIG. 5, the actuators 122 are respectively formed on or attached to one side of the membrane units MU. In this way, the membrane units MU may bend to one direction so as to perform the horizontal deformation. More specifically, when all bias electrodes (i.e. electrode 122_a of each of the membrane units MU) are connected to Vbias, a connection order for the driving electrodes corresponding to the membrane units MU respectively in FIG. 5 is S+, S-, S+, S-... Dot lines and cross lines in FIG. 5 illustrate positions of the membrane units MU when the dual polarity driving signals S+ and S- reach the peak and valley of the driving signal, which correspond to the peak displacement of the membrane units MU. Therefore, with the displacement of the membrane units MU, the air in the chamber will be moved in and out of the air pulse generating element 10, and thus produce sound pressure level and sound wave.

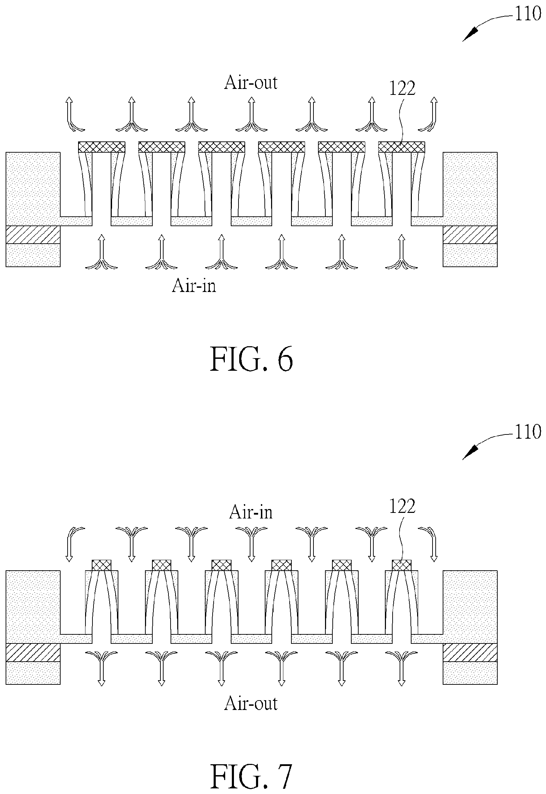

In an embodiment, please refer to FIGs. 6-9, the 1-layer and the 2-layer piezoelectric actuators 122 are placed on the horizontal surfaces of the folded membrane. FIGs. 6 and 7 respectively illustrate air-out phase and air-in phase when the 1-layer piezoelectric actuators 122 are formed on the folded membrane 110. More specifically, the actuators 122 are formed on a top surface of the folded membrane 110. Therefore, when the driving signals S+, S- are applied on the actuators 122, the actuators 122 expand horizontally due to piezoelectric effect and deform the folded membrane 110 and squeeze out or suck the air.

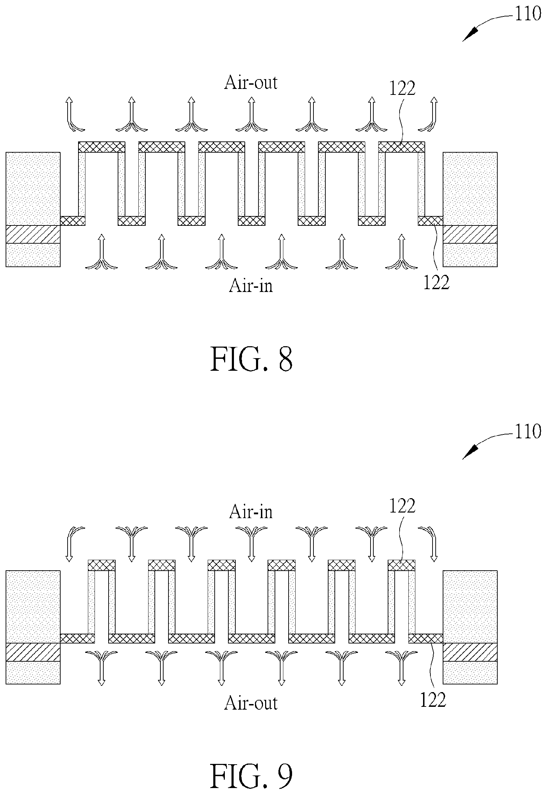

FIGs. 8 and 9 respectively illustrate the air-out phase and the air-in phase when the 2-layer piezoelectric actuators 122 are formed on the folded membrane 110. More specifically, the 2-layer piezoelectric actuators are deposited on both top and bottom sides of the folded membrane 110 to create a more symmetric and larger horizontal deformation compared with FIGs 6 and 7. Therefore, when the driving signals S+, S- are applied on the actuators 122, the actuators 122 deform the folded membrane 110 and squeeze out or suck the air. Notably, the piezoelectric material may be implemented by PZT, ZnO, AIN or AIScN. In another embodiment, other types of the actuators 122, such as, electro-thermal type, may be incorporated thereto.

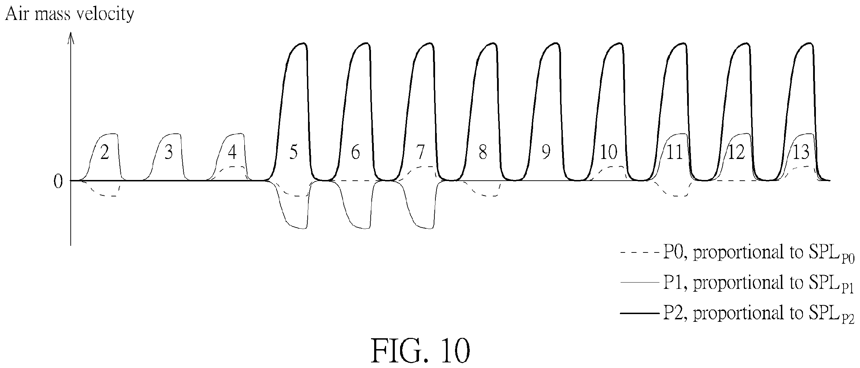

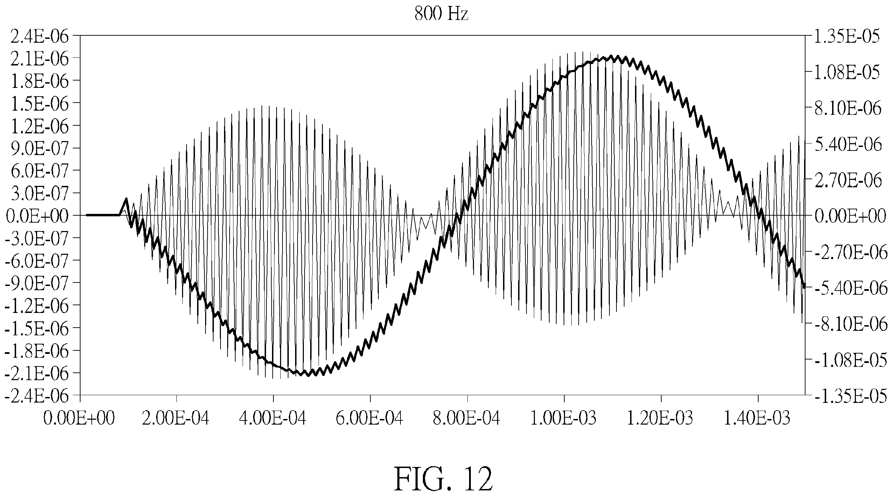

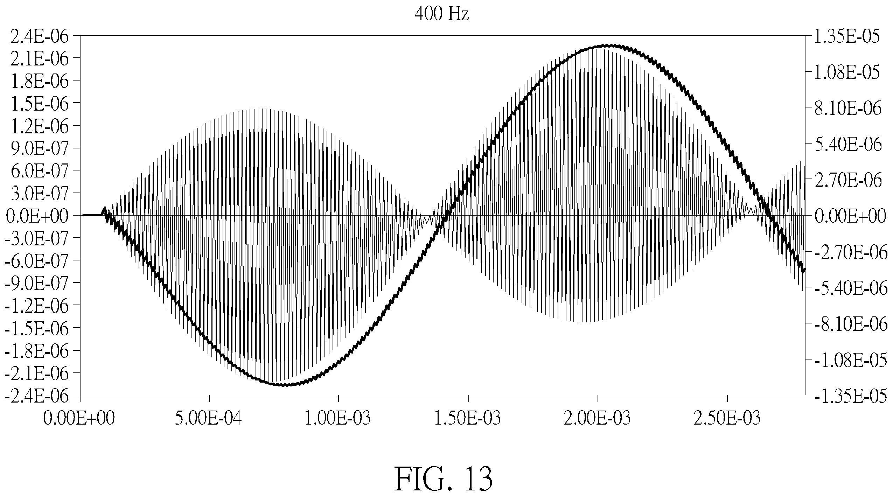

The air pulse generating element 10 may generate a series of air pulses at a pulse rate, as shown in FIGs. 10-13, where the pulse rate is significantly higher than the maximum human audible frequency. The pulse rate may be an ultrasonic rate, e.g., 64 KHz, significantly higher than twice of the maximum human audible frequency, which is generally considered to be 20K Hz. This pulse rate is determined based on Nyquist law, which states, in order to avoid frequency spectral aliasing, the pulse rate needs to be at least twice higher than the maximum frequency of the input audio signal. The series/plurality of air pulses generated by the air pulse generating element 10 may be referred as an ultrasonic pulse array (UPA). In an embodiment, the pulse rate may be an ultrasonic rate, e.g., 64 KHz, significantly higher than twice of the maximum human audible frequency, which is generally considered to be 20K Hz. This pulse rate is determined based on Nyquist law, which states, in order to avoid frequency spectral aliasing, the pulse rate needs to be at least twice higher than the maximum frequency of the input audio signal. The series/plurality of air pulses generated by the air pulse generating element 10 may be referred as an ultrasonic pulse array (UPA).

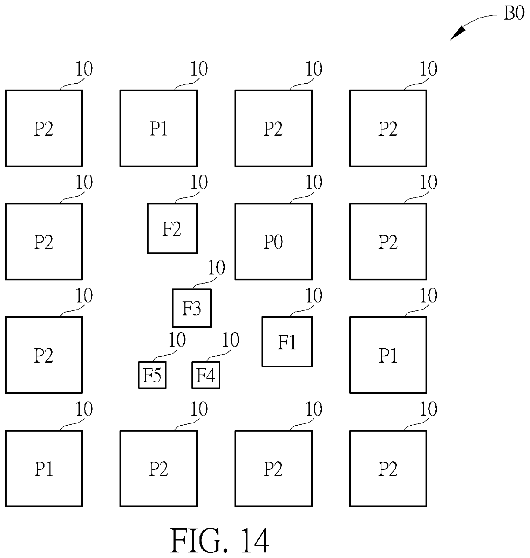

In the embodiment illustrated in FIG. 14, multiple air pulse generating elements 10 are grouped into air pulse generating groups labeled as P0, P1, P2, and F1-F5 as a sound producing device B0. The air pulse generating group P2 includes 9 air pulse generating elements 10, the air pulse generating group P1 includes 3 air pulse generating elements 10, and the air pulse generating groups P0 and F1-F5 includes 1 air pulse generating element 10, respectively. Details of the sound producing device B0 may be referred to U.S. Application No. 16/125,761, which is not narrated herein for brevity.

In addition, please refer to FIG. 10, the air-flow speed, i.e., the air mass velocity, with respect to time produced by the air pulse generating groups P0, P1 and P2 over 12 consecutive air pulse cycles are shown. The amplitudes of SPL corresponding to the three air pulse generating groups P0, P1 and P2, denoted as SPLP0, SPLP1 and SPLP2, have a ratio relationship of SPLP0 : SPLP1 : SPLP2 = 1 : 3 : 9 in between. The "0" state representing "Speed = 0" is omitted for brevity. Each air pulse generating group may arbitrarily generate a positive pulse (corresponding to the "+1" state), a negative pulse (corresponding to the "-1" state), or a null pulse (corresponding to the "0" state) within a certain pulse cycle PC, regardless of the polarity of previous air pulse. As FIG. 10 shows, the air pulse generating group P2 starts with 3 null pulses, and finishes with 9 consecutives positive pulses; the air pulse generating group P1 starts with 3 positive pulses, followed by 3 negative pulses and 3 null pulses, and finishes with 3 positive pulses; and the air pulse generating group P0 repeatedly generates a negative pulse, a null pulse and a positive pulse, in 4 iterations. Therefore, the resulting aggregated SPLs generated by the air pulse generating elements 10, including the air pulse generating groups P0, P1 and P2, over the consecutive 12 cycles has a ratio of 2 : 3 : 4 : 5 : 6 : 7 : 8 : 9 : 10 : 11 : 12 : 13, as shown in scalar form in FIG. 10. In this regard, the UPA, i.e., the series/plurality of air pulses generated by the air pulse generating elements 10 may be amplitude modulated. Note that, the SPL is a first-order derivative of air mass velocity with respect to time.

Similarly, the air pulse generating groups F1-F5 may be designed such that the amplitude of SPL generated by the air pulse generating group Fy (or the air pulse generating element within the air pulse generating group Fy) is 1/3y of the SPLP0, where y may be 1,...,5. The fractional air pulse generating elements (i.e., the air pulse generating elements of the air pulse generating groups F1-F5) may be accomplished either by shrinking the geometry of the full cell (i.e., the air pulse generating element of the air pulse generating group P0), or by reducing the piezoelectric to membrane coverage ratio.

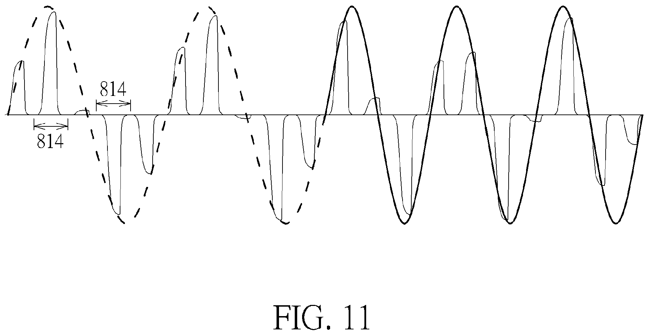

Refer to FIG. 11, a pulse array or a series/plurality of air pulses generated by the air pulse generating elements 10 according to a sinusoidal sound wave is illustrated. A plurality of air pulses, shown in solid line, is generated over a plurality of fixed cycles 814. An amplitude and a polarity of each pulse are related to an amplitude and a polarity of a sample of the sinusoidal sound wave. In other words, the plurality of air pulses generated by the air pulse generating elements 10 is regarded as being amplitude-modulated (AM) according to the sinusoidal sound wave. Similarly, the plurality of air pulses generated by the air pulse generating elements 10 may be amplitude-modulated according to an input audio signal, which means that an amplitude and a polarity of each pulse are related to an amplitude and a polarity of a time-sample of the input audio signal, wherein the time-sample of the input audio signal represents an instantaneous value of the input audio signal sampled at a sampling time instant.

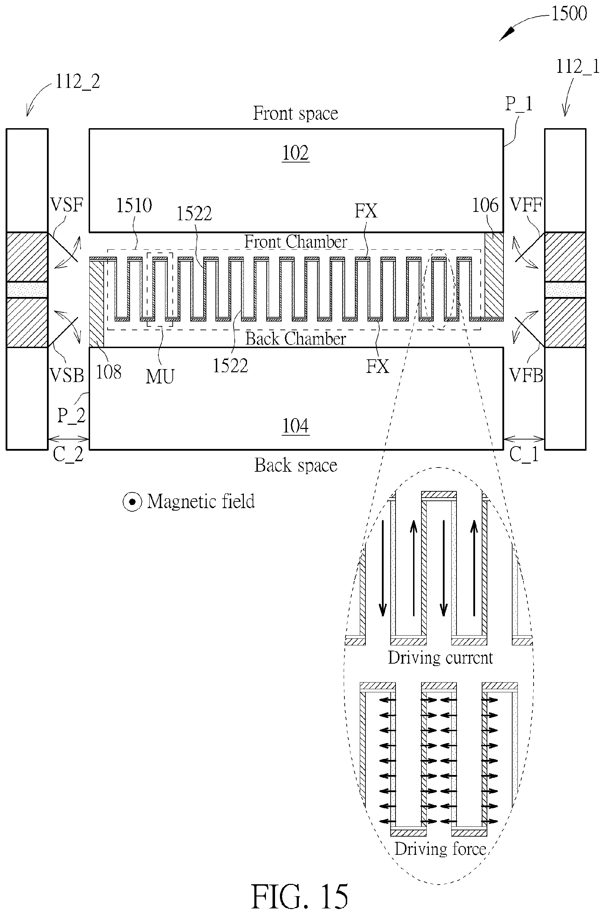

According to different applications or concepts, the air pulse generating element 10 may be implemented by all kinds of methods. Please refer to FIG. 15, which is a schematic diagram of a cross-sectional view of an air pulse generating element 1500 according to another embodiment of the present application with electromagnetic actuators. Different with the air pulse generating element 10, a folded membrane 1510 of the air pulse generating element 1500 is incorporated with electromagnetic actuators 1522, and the else elements with the same function share the same notion with FIG. 1. In FIG. 15, when a driving current flows along the folded membrane 1510, under an influence of external magnetic field, the membrane units MU is configured to perform the horizontal deformation corresponding to a driving force of the Lorentz effect generated by an interaction of the magnetic field and the driving current flow. The horizontal deformation of folded membrane 1510 causes the air in the chamber to be moved in and out of the front chamber and the back chamber, and thus, the air pulse generating element 1500 produce sound pressure level and sound wave.

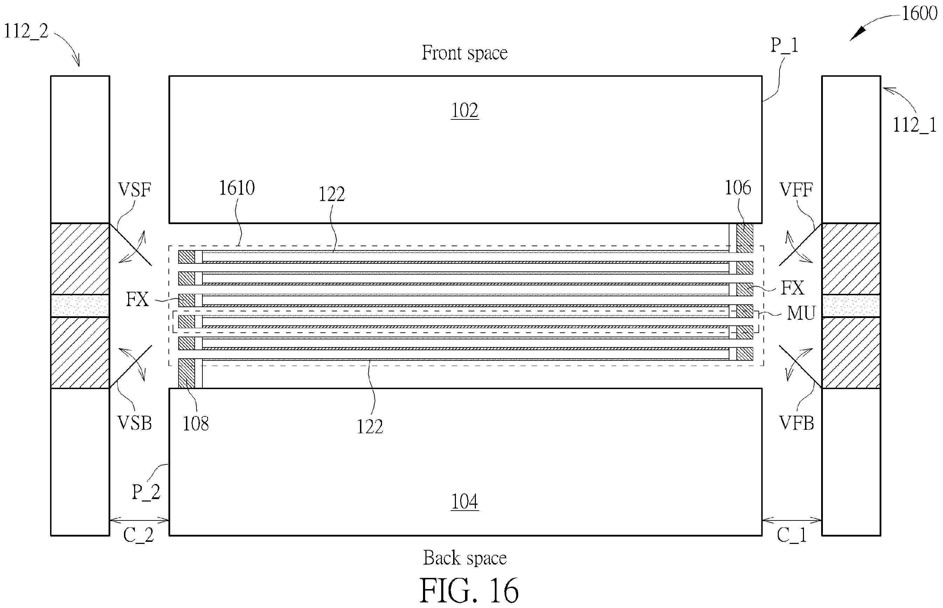

In addition, in another example, the folded membrane 110 is not limited to the structure illustrated in FIG. 1. Please refer to FIG. 16, which is a cross-sectional view of an air pulse generating element 1600 according to another embodiment of the present application. In order to increase a membrane area, the folded membrane 1610 may be disposed horizontally, and likewise deform vertically in one or two directions, to produce sound pressure level and sound wave.

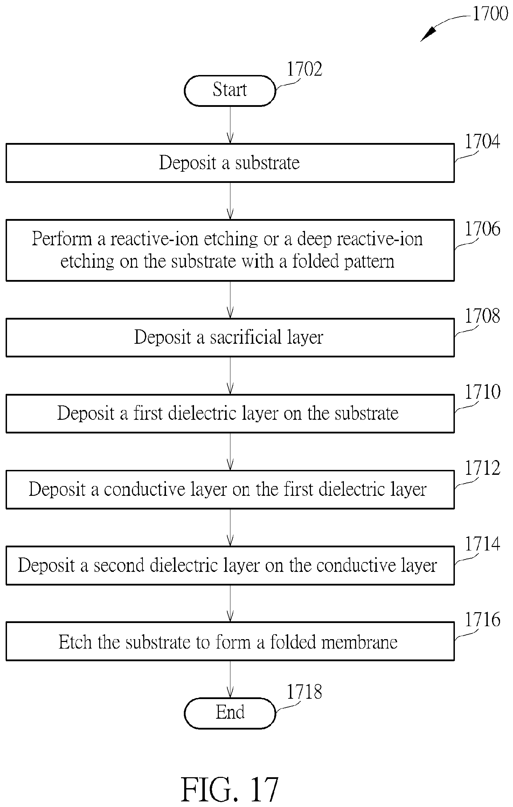

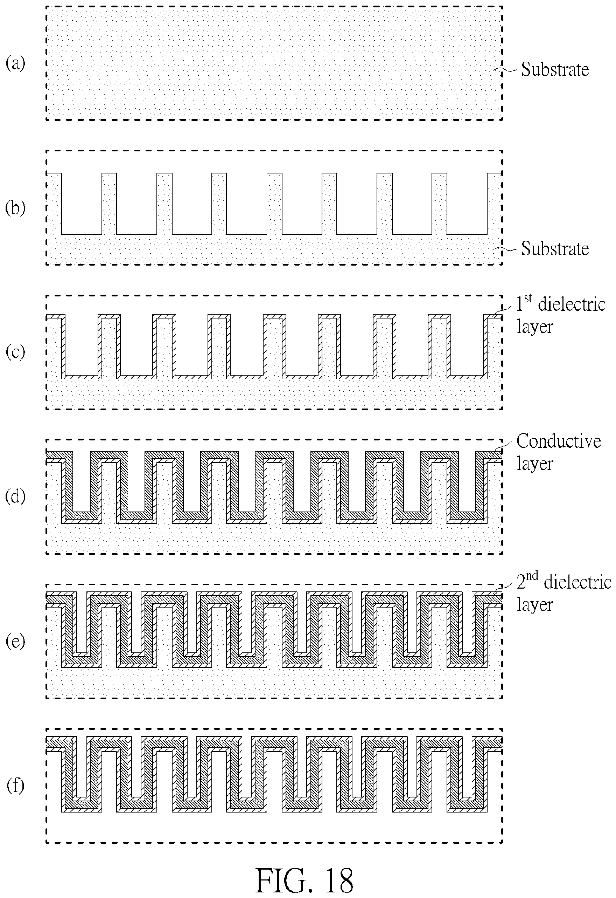

Further, please refer to FIG. 17, which is a schematic diagram of a manufacturing process 1700 for manufacturing the folded membrane 110 of air pulse generating element 10 according to an embodiment of the present application. In addition, FIG. 18 is a structural diagram corresponding to the manufacturing process 1700 shown in FIG. 17. The manufacturing process 1700 includes the following steps:
Step 1702: Start.
Step 1704: Deposit a substrate.
Step 1706: Perform a reactive-ion etching (RIE) or a deep reactive-ion etching (DRIE) on the substrate with a folded pattern.
Step 1708: Deposit a sacrificial layer.
Step 1710: Deposit a first dielectric layer on the substrate.
Step 1712: Deposit a conductive layer on the first dielectric layer.
Step 1714: Deposit a second dielectric layer on the conductive layer.
Step 1716: Etch the substrate to form a folded membrane.
Step 1718: End.

According to the manufacturing process 1700, a metallic membrane is manufactured by a thin conductive layer and isolated by two dielectric layers. First, in step 1704, which corresponds to FIG. 18(a), the substrate is deposited, which may be a silicon substrate. In step 1706, which corresponds to FIG. 18(b), the RIE or the DRIE etching is performed on the folded substrate. In step 1708, the sacrificial layer is deposited. In step 1710, which corresponds to FIG. 18(c), the first dielectric is deposited. In step 1712, which corresponds to FIG. 18(d), the conductive layer may be deposited by means of LPCVD for poly-silicon or sputter for a metal film. In step 1714, which corresponds to FIG. 18(e), the second dielectric layer is deposited to accomplish the folded membrane without electrical isolation. In addition, step 1708 is optional to the manufacturing process 1700. When the sacrificial layer is deposited before the depositing the first dielectric layer on the substrate, in step 1716, which corresponds to FIG. 18(f), the membrane 110 is released from the silicon substrate by etching the sacrificial layer after depositing the second dielectric layer on the conductive layer. Notably, the pair of the conductive and the dielectric material of the folded membrane may be Poly-Si and SiO2, Poly-Si and SiN or Metals and polymer, which are within the scope of the present application.

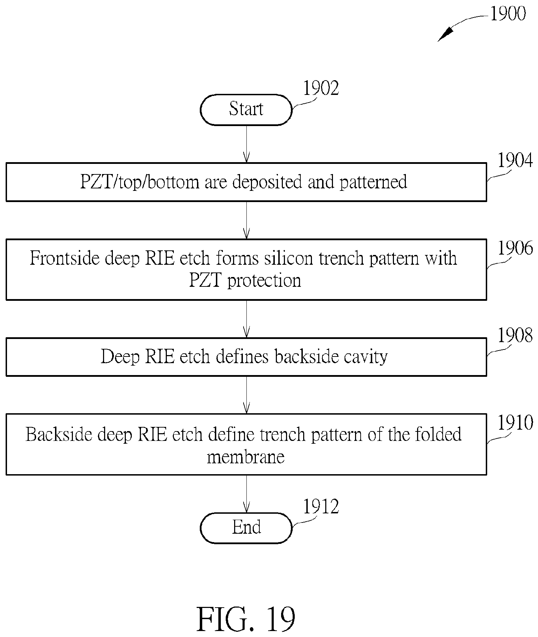

Aforementioned process in FIG. 17 can be used to fabricate the electrostatic or electromagnetic actuator on folded membrane in FIG. 11. In another embodiment, please refer to FIG. 19, which is a schematic diagram of a manufacturing process 1900 for manufacturing the folded membrane with piezoelectric actuators of air pulse generating element according to an embodiment of the present application. The manufacturing process 1900 includes the following steps:
Step 1902: Start.
Step 1904: PZT/top/bottom are deposited and patterned.
Step 1906: Frontside deep RIE etch forms silicon trench pattern with PZT protection.
Step 1908: Deep RIE etch defines backside cavity.
Step 1910: Backside deep RIE etch define trench pattern of the folded membrane.
Step 1912: End.

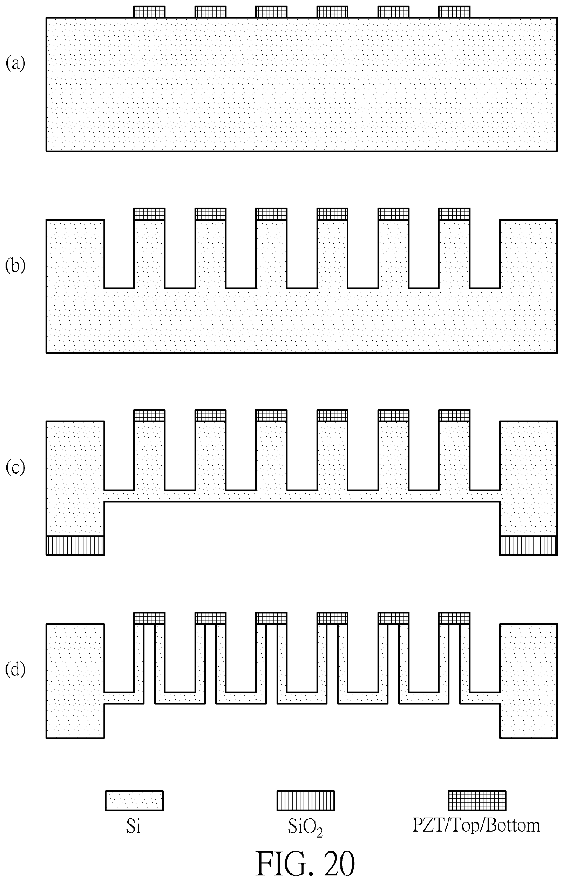

In addition, FIG. 20 is a structural diagram corresponding to the manufacturing process 1900 shown in FIG. 19. FIG. 20(a)-20(d) respectively corresponds to Step 1904 to Step 1910. Notably, the piezoelectric actuators are deposited and patterned on etching silicon to fabricate piezoelectric actuator on folded membrane 110 in FIGs. 6-9.

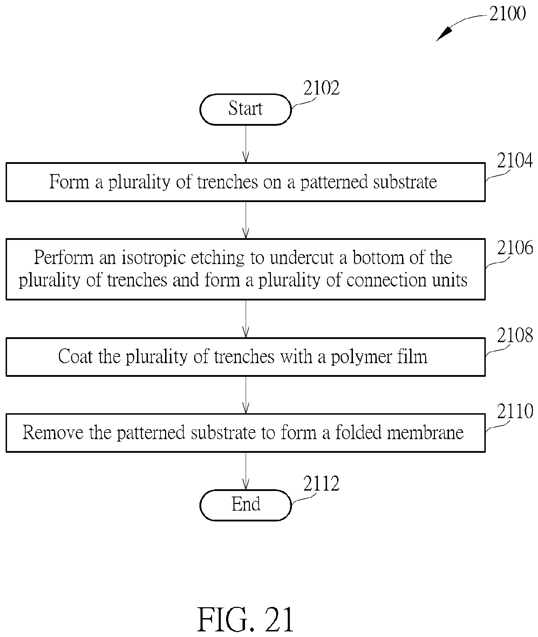

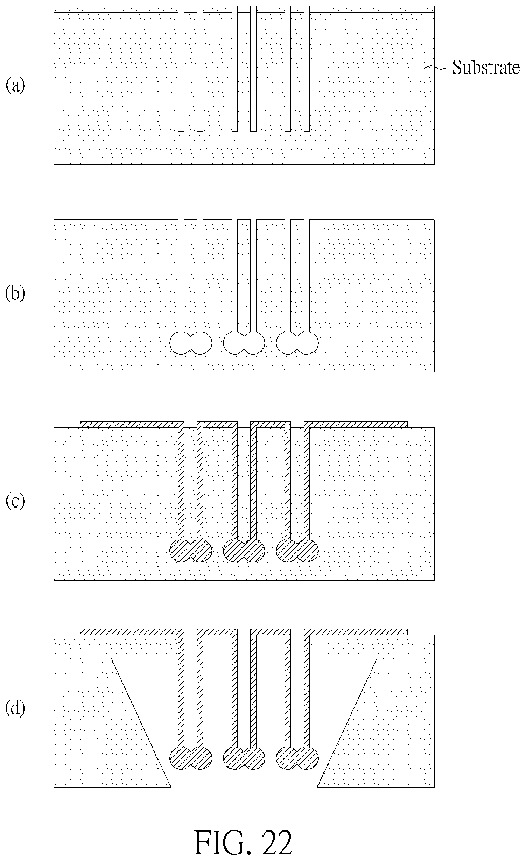

Please refer to FIG. 21, which is a schematic diagram of a manufacturing process 2100 for manufacturing the folded membrane 110 of the air pulse generating element 10 according to another embodiment of the present application. FIG. 22 is a structural diagram corresponding to the manufacturing process 2100 shown in FIG. 21. The manufacturing process 2100 includes the following steps:
Step 2102: Start.
Step 2104: Form a plurality of trenches on a patterned substrate.
Step 2106: Perform an isotropic etching to undercut a bottom of the plurality of trenches and form a plurality of connection units.
Step 2108: Coat the plurality of trenches with a polymer film.
Step 2110: Remove the patterned substrate to form a folded membrane.
Step 2112: End.

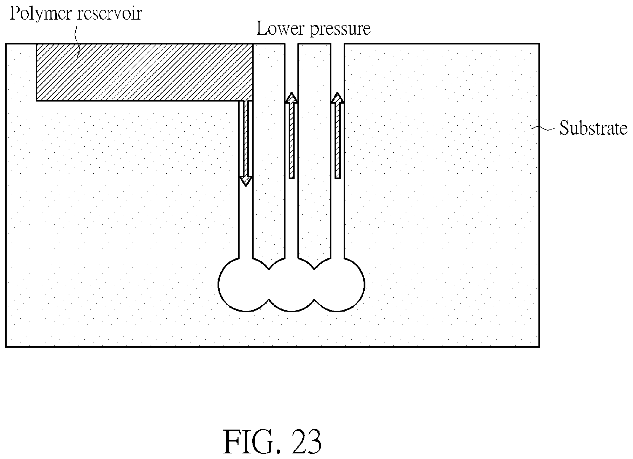

According to the manufacturing process 2100, a polymer-based folded membrane is manufactured. In step 2104, which corresponds to FIG. 22(a), the trenches are formed on the silicon substrate by the DRIE method or the RIE method. In step 2106, which corresponds to FIG. 22(b), the isotropic etching is performed to undercut the bottom of the trenches to form the connection units. In step 2108, which corresponds to FIG. 22(c), every two of the connection units are connected to each other when coating the trenches with the polymer film. In step 2110, which corresponds to FIG. 22(d), the polymer membrane is released by removing the silicon substrate. Notably, the polymer-based membrane has lower stiffness and results in larger displacement with identical driving force compared with the metallic-based membrane. In addition, other materials of the polymer-based membrane may be implemented such as dry film, Benzocyclobutene(BCB), Parylene(Poly-p-xylene) for non-conductive type; Polydimethylsiloxane(PDMS), Poly-3,4-Ethylenedioxythiophene (PEDOT), polyaniline(PANI), Polythiophenes(PTs), poly(p-phenylene sulfide)(PPS), poly(p-phenylene vinylene)(PPV) and Poly(acetylene)(PAC) for conductive type. There are several polymer coating methods including spin coating, spray coating, film laminating, and polymer filling. As shown in FIG. 23, the polymer filling has polymer reservoir, which is connected to trenches formed by the process of DRIE and isotropic etching to undercut the bottom of the trenches. After the injection of polymer liquid into the polymer reservoir, lower pressure is created and the polymer flows into the trenches to form a folded membrane with high aspect ratio.

Therefore, the present application provides an air pulse generating element and manufacturing method, and more particularly, which is capable of increasing the membrane area, producing high fidelity sound and enough sound pressure.

## Claims

1. An air pulse generating element (10, 1500, 1600) comprising:
a front faceplate (102);
a back faceplate (104);
a front supporting element (106), connected to the front faceplate (102);
a back supporting element (108), connected to the back faceplate (104);
a folded membrane (110, 1510, 1610), configured to form a front chamber and a back chamber, and comprising a plurality of membrane units (MU); wherein the plurality of membrane units (MU) are parallel and sequentially connected and an end of the folded membrane (110, 1510, 1610) is connected to the back faceplate (104) via the back supporting element (108) and another end of the folded membrane (110, 1510, 1610) is connected to the front faceplate (102) via the front supporting element (106);
a first wall (112_1), disposed along a first plane (P_1) corresponding to a side of the front supporting element (106) with a first air flow channel (C_1)
a second wall (112_2), disposed along a second plane (P_2) corresponding to a side of the back supporting element (108) with a second air flow channel (C_2); and
a plurality of valves (VFF, VFB, VSF, VSB) controlling the first and second air flow channels (C_1, C_2) between the front chamber toward either a front space or a back space, and between the back chamber toward either the front space or the back space;
a plurality of actuators (122, 1522), each formed on a side of a membrane unit of the plurality of membrane units (MU);
wherein the plurality of membrane units (MU) are configured to perform horizontal deformation to squeeze air in and out of the front or back chamber with operations of the plurality of valves (VFF, VFB, VSF, VSB) controlling the direction of the air pulse toward the front space or the back space;
wherein a first front valve (VFF) and a first back valve (VFB) of the plurality of valves (VFF, VFB, VSF, VSB) are connected to the front space or the back space at the first wall (112_1), and are disposed between the first wall (112_1) and the front supporting element (106);
wherein a second front valve (VSF) and a second back valve (VSB) of the plurality of valves (VFF, VFB, VSF, VSB) are connected to the front space or the back space at the second wall (112_2), and are disposed between the second wall (112_2) and the back supporting element (108);
wherein the plurality of actuators (122, 1522) are mounted on the plurality of membrane units (MU), such that the plurality of membrane units (MU) flexibly perform the horizontal deformation.

2. The air pulse generating element (10, 1500, 1600) of claim 1, wherein the first front valve (VFF) is controlled by a first front valve-controlling signal to control an airflow through the front faceplate (102); the first back valve (VFB), controlled by a first back valve-controlling signal to control the airflow through the back faceplate (104); the second front valve (VSF), controlled by a second front valve-controlling signal to control the airflow through the front faceplate (102); and the second back valve (VSB), controlled by a second back valve-controlling signal to control the airflow through the back faceplate (104).

3. The air pulse generating element (10, 1500, 1600) of claim 2, wherein the first front valve-controlling signal equals the second back valve-controlling signal, and the first back valve-controlling signal equals the second front valve-controlling signal.

4. The air pulse generating element (10, 1500, 1600) of claim 1, wherein the plurality of actuators (122, 1522) are electrostatic actuators with a plurality of electrodes, such that the plurality of membrane units (MU) perform the horizontal deformation when a plurality of driving charges are applied on the plurality of electrodes.

5. The air pulse generating element (10, 1500, 1600) of claim 1, wherein the plurality of actuators (122, 1522) are piezoelectric actuators with a plurality of electrodes, such that the plurality of membrane units (MU) perform the horizontal deformation when a plurality of driving charges are applied on the plurality of electrodes.

6. The air pulse generating element (10, 1500, 1600) of claim 1, wherein the folded membrane (110, 1510, 1610) is incorporated with electromagnetic actuator and a current flows along the folded membrane (110, 1510, 1610), such that the plurality of membrane units (MU) perform the horizontal deformation.

7. The air pulse generating element (10, 1500, 1600) of claim 1, wherein the air pulse generating element (10, 1500, 1600) is configured to receive an input audio signal, and an amplitude and a polarity of each air pulse generated by the air pulse generating element (10, 1500, 1600) are related to a amplitude and a polarity of a time-sample of the input audio signal.

8. The air pulse generating element (10, 1500, 1600) of claim 1, wherein a driving voltage is applied to each of the plurality of actuators (122, 1522) of the air pulse generating element (10, 1500, 1600), such that the air pulse generating element (10, 1500, 1600) generates a plurality of air pulses in response to the driving voltage; a plurality of air pulses are at a pulse rate, and the pulse rate of the plurality of air pulses is higher than a maximum audible frequency.

9. The air pulse generating element (10, 1500, 1600) of claim 8, wherein the pulse rate of the plurality of air pulses is at least twice higher than a maximum frequency of an input audio signal to be reproduced.

10. The air pulse generating element (10, 1500, 1600) of claim 8, wherein the pulse rate of the plurality of air pulses is at least twice higher than a maximum audible frequency.

11. The air pulse generating element (10, 1500, 1600) of claim 1, wherein a direction of an air mass velocity within a pulse cycle is in a front-to-back direction or a back-to-front direction regardless an initial position of the folded membrane (110, 1510, 1610), and a plurality of valve-controlling signals are generated to the plurality of valves (VFF, VFB, VSF, VSB) to perform an open-and-close movement.

12. The air pulse generating element (10, 1500, 1600) of claim 11, wherein the horizontal deformation performed by the plurality of membrane units (MU) and the open-and-close movement performed by the plurality of valves (VFF, VFB, VSF, VSB) are mutually synchronized.

13. A manufacturing method (1700) for the folded membrane (110, 1510, 1610) of the air pulse generating element (10, 1500, 1600) of claim 1 comprising:
depositing a substrate (1704);
performing a reactive-ion etching, which is RIE, or a deep reactive-ion etching, which is DRIE, on the substrate with a folded pattern (1706);
depositing a first dielectric layer on the substrate (1710);
depositing a conductive layer on the first dielectric layer (1712);
depositing a second dielectric layer on the conductive layer (1714); and
etching the substrate to form the folded membrane (1716).

14. The manufacturing method of claim 13, further comprising:
depositing a sacrificial layer before depositing the first dielectric layer on the substrate (1708).

15. The manufacturing method of claim 14, further comprising:
etching the sacrificial layer after depositing the second dielectric layer on the conductive layer.

16. A manufacturing method (2100) for the folded membrane (110, 1510, 1610) of the air pulse generating element (10, 1500, 1600) of claim 1 comprising:
forming a plurality of trenches on a patterned substrate (2104);
performing an isotropic etching to undercut a bottom of the plurality of trenches and forming a plurality of connection units (2106);
coating the plurality of trenches with a polymer film (2108); and
removing the patterned substrate to form the folded membrane (2110).

## Patentansprüche

1. Luftimpulserzeugungselement (10, 1500, 1600), welches umfasst:
eine vordere Stirnplatte (102);
eine hintere Stirnplatte (104);
ein vorderes Stützelement (106), das mit der vorderen Stirnplatte (102) verbunden ist;
ein hinteres Stützelement (108), das mit der hinteren Stirnplatte (104) verbunden ist;
eine gefaltete Membran (110, 1510, 1610), die ausgestaltet ist, eine vordere Kammer und eine hintere Kammer zu bilden, und die mehrere Membraneinheiten (MU) umfasst; worin die mehreren Membraneinheiten (MU) parallel und sequentiell verbunden sind und ein Ende der gefalteten Membran (110, 1510, 1610) mit der hinteren Stirnplatte (104) über das hintere Stützelement (108) verbunden ist und ein anderes Ende der gefalteten Membran (110, 1510, 1610) mit der vorderen Stirnplatte (102) über das vordere Stützelement (106) verbunden ist;
eine erste Wand (112_1), die entlang einer ersten Ebene (P_1) angeordnet ist, die einer Seite des vorderen Stützelements (106) mit einem ersten Luftstromkanal (C_1) entspricht;
eine zweite Wand (112_2), die entlang einer zweiten Ebene (P_2) angeordnet ist, die einer Seite des hinteren Stützelements (108) mit einem zweiten Luftstromkanal (C_2) entspricht; und
mehrere Ventile (VFF, VFB, VSF, VSB), die die ersten und zweiten Luftstromkanäle (C_1, C_2) zwischen der vorderen Kammer entweder zu einem vorderen Raum oder einem hinteren Raum und zwischen der hinteren Kammer entweder zu dem vorderen Raum oder dem hinteren Raum steuern;
mehrere Aktuatoren (122, 1522), die jeweils auf einer Seite einer Membraneinheit der mehreren Membraneinheiten (MU) ausgebildet sind;
wobei die mehreren Membraneinheiten (MU) ausgestaltet sind, eine horizontale Verformung durchführen, um Luft in die vordere oder hintere Kammer hinein und heraus zu pressen, wobei die Betätigungen der mehreren Ventile (VFF, VFB, VSF, VSB) die Richtung des Luftimpulses in Richtung des vorderen Raums oder des hinteren Raums steuern;
wobei ein erstes vorderes Ventil (VFF) und ein erstes hinteres Ventil (VFB) der mehreren Ventile (VFF, VFB, VSF, VSB) mit dem vorderen Raum oder dem hinteren Raum an der ersten Wand (112_1) verbunden sind und zwischen der ersten Wand (112_1) und dem vorderen Stützelement (106) angeordnet sind;
wobei ein zweites vorderes Ventil (VSF) und ein zweites hinteres Ventil (VSB) der mehreren Ventile (VFF, VFB, VSF, VSB) mit dem vorderen Raum oder dem hinteren Raum an der zweiten Wand (112_2) verbunden sind und zwischen der zweiten Wand (112_2) und dem hinteren Stützelement (108) angeordnet sind;
wobei die mehreren Aktuatoren (122, 1522) an den mehreren Membraneinheiten (MU) angebracht sind, so dass die mehreren Membraneinheiten (MU) flexibel die horizontale Verformung durchführen.

2. Luftimpulserzeugungselement (10, 1500, 1600) nach Anspruch 1, wobei das erste vordere Ventil (VFF) durch ein erstes vorderes Ventilsteuersignal gesteuert wird, um einen Luftstrom durch die vordere Stirnplatte (102) zu steuern; das erste hintere Ventil (VFB) durch ein erstes hinteres Ventilsteuersignal gesteuert wird, um den Luftstrom durch die hintere Stirnplatte (104) zu steuern; das zweite vordere Ventil (VSF) durch ein zweites vorderes Ventilsteuersignal gesteuert wird, um den Luftstrom durch die vordere Stirnplatte (102) zu steuern; und das zweite hintere Ventil (VSB) durch ein zweites hinteres Ventilsteuersignal gesteuert wird, um den Luftstrom durch die hintere Stirnplatte (104) zu steuern.

3. Luftimpulserzeugungselement (10, 1500, 1600) nach Anspruch 2, worin das erste Steuersignal für das vordere Ventil gleich dem zweiten Steuersignal für das hintere Ventil ist, und das erste Steuersignal für das hintere Ventil gleich dem zweiten Steuersignal für das vordere Ventil ist.

4. Luftimpulserzeugungselement (10, 1500, 1600) nach Anspruch 1, worin die mehreren Aktuatoren (122, 1522) elektrostatische Aktuatoren mit mehreren Elektroden sind, so dass die mehreren Membraneinheiten (MU) die horizontale Verformung durchführen, wenn mehrere Antriebsladungen an die mehreren Elektroden angelegt werden.

5. Luftimpulserzeugungselement (10, 1500, 1600) nach Anspruch 1, worin die mehreren Aktuatoren (122, 1522) piezoelektrische Aktuatoren mit mehreren Elektroden sind, so dass die mehreren Membraneinheiten (MU) die horizontale Verformung durchführen, wenn mehrere Antriebsladungen auf die mehreren Elektroden aufgebracht werden.

6. Luftimpulserzeugungselement (10, 1500, 1600) nach Anspruch 1, wobei, wenn die gefaltete Membran (110, 1510, 1610) mit einem elektromagnetischen Aktuator verbunden ist und ein Strom entlang der gefalteten Membran (110, 1510, 1610) fließt, die mehreren Membraneinheiten (MU) die horizontale Verformung durchführen.

7. Luftimpulserzeugungselement (10, 1500, 1600) nach Anspruch 1, wobei das Luftimpulserzeugungselement (10, 1500, 1600) ausgestaltet ist, ein Eingangsaudiosignal zu empfangen, und eine Amplitude und eine Polarität jedes von dem Luftimpulserzeugungselement (10, 1500, 1600) erzeugten Luftimpulses mit einer Amplitude und einer Polarität einer Zeitprobe des Eingangsaudiosignals in Beziehung stehen.

8. Luftimpulserzeugungselement (10, 1500, 1600) nach Anspruch 1, wobei eine Ansteuerspannung an jeden der mehreren Aktuatoren (122, 1522) des Luftimpulserzeugungselements (10, 1500, 1600) angelegt wird, so dass das Luftimpulserzeugungselement (10, 1500, 1600) als Reaktion auf die Ansteuerspannung mehrere Luftimpulse erzeugt, wobei mehrere Luftimpulse eine Impulsrate aufweisen und die Impulsrate der mehreren Luftimpulse höher als eine maximale hörbare Frequenz ist.

9. Luftimpulserzeugungselement (10, 1500, 1600) nach Anspruch 8, wobei die Impulsrate der mehreren Luftimpulse mindestens doppelt so hoch ist wie eine maximale Frequenz eines zu reproduzierenden Eingangsaudiosignals.

10. Luftimpulserzeugungselement (10, 1500, 1600) nach Anspruch 8, wobei die Impulsrate der mehreren Luftimpulse mindestens zweimal höher ist als eine maximale hörbare Frequenz.

11. Luftimpulserzeugungselement (10, 1500, 1600) nach Anspruch 1, wobei eine Richtung einer Luftmassengeschwindigkeit innerhalb eines Impulszyklus in einer Richtung von vorne nach hinten oder von hinten nach vorne liegt, unabhängig von einer Anfangsposition der gefalteten Membran (110, 1510, 1610), und wobei mehrere Ventilsteuersignale für die mehreren Ventile (VFF, VFB, VSF, VSB) erzeugt werden, um eine Öffnungs- und Schließbewegung durchzuführen.

12. Luftimpulserzeugungselement (10, 1500, 1600) nach Anspruch 11, wobei die horizontale Verformung, die von den mehreren Membraneinheiten (MU) durchgeführt wird, und die Öffnungs- und Schließbewegung, die von den mehreren Ventilen (VFF, VFB, VSF, VSB) durchgeführt wird, gegenseitig synchronisiert sind.

13. Herstellungsverfahren (1700) für die gefaltete Membran (110, 1510, 1610) des Luftimpulserzeugungselements (10, 1500, 1600) nach Anspruch 1, welches umfasst:
Aufbringen eines Substrats (1704);
Durchführen eines reaktiven Ionenätzens, das als RIE bezeichnet wird, oder eines tiefen reaktiven Ionenätzens, das als DRIE bezeichnet wird, auf dem Substrat mit einem gefalteten Muster (1706);
Aufbringen einer ersten dielektrischen Schicht auf dem Substrat (1710);
Aufbringen einer leitenden Schicht auf der ersten dielektrischen Schicht (1712);
Aufbringen einer zweiten dielektrischen Schicht auf der leitenden Schicht (1714); und
Ätzen des Substrats, um die gefaltete Membran (1716) zu bilden.

14. Herstellungsverfahren nach Anspruch 13, welches ferner umfasst:
Aufbringen einer Opferschicht vor dem Aufbringen der ersten dielektrischen Schicht auf dem Substrat (1708).

15. Herstellungsverfahren nach Anspruch 14, welches ferner umfasst:
Ätzen der Opferschicht nach dem Aufbringen der zweiten dielektrischen Schicht auf die leitende Schicht.

16. Herstellungsverfahren (2100) für die gefaltete Membran (110, 1510, 1610) des Luftimpulserzeugungselements (10, 1500, 1600) nach Anspruch 1, welches umfasst:
Ausbilden mehrerer Gräben auf einem gemusterten Substrat (2104);
Durchführen eines isotropen Ätzens, um einen Boden der mehreren Gräben zu unterschneiden und mehrere Verbindungseinheiten (2106) auszubilden;
Beschichten der mehreren Gräben mit einem Polymerfilm (2108); und
Entfernen des strukturierten Substrats, um die gefaltete Membran (2110) auszubilden.

## Revendications

1. Elément de génération d'impulsion d'air (10, 1500, 1600), comprenant:
une plaque frontale avant (102);
une plaque frontale arrière (104);
un élément de support avant (106), relié à la plaque frontale avant (102);
un élément de support arrière (108), relié à la plaque frontale arrière (104);
une membrane pliée (110, 1510, 1610), configurée pour former une chambre avant et une chambre arrière, et comprenant une pluralité d'unités de membrane (MU); dans laquelle la pluralité d'unités de membrane (MU) sont connectées parallèlement et séquentiellement et une extrémité de la membrane pliée (110, 1510, 1610) est connectée à la plaque frontale arrière (104) via l'élément de support arrière (108) et une autre extrémité de la membrane pliée (110, 1510, 1610) est connectée à la plaque frontale avant (102) via l'élément de support avant (106);
une première paroi (112_1), disposée le long d'un premier plan (P_1) correspondant à un côté de l'élément de support avant (106) avec un premier canal d'écoulement d'air (C_1);
une deuxième paroi (112_2), disposée le long d'un deuxième plan (P_2) correspondant à un côté de l'élément de support arrière (108) avec un deuxième canal d'écoulement d'air (C_2); et
une pluralité de vannes (VFF, VFB, VSF, VSB) commandant les premier et deuxième canaux d'écoulement d'air (C_1, C_2) entre la chambre avant vers un espace avant ou un espace arrière, et entre la chambre arrière vers l'espace avant ou l'espace arrière;
une pluralité d'actionneurs (122, 1522), chacun formé sur un côté d'une unité de membrane de la pluralité d'unités de membrane (MU);
dans lequel la pluralité d'unités de membrane (MU) sont configurées pour effectuer une déformation horizontale pour presser l'air dans et hors de la chambre avant ou arrière avec des opérations de la pluralité de vannes (VFF, VFB, VSF, VSB) contrôlant la direction de l'impulsion d'air vers l'espace avant ou l'espace arrière;
dans lequel une première vanne avant (VFF) et une première vanne arrière (VFB) de la pluralité de vannes (VFF, VFB, VSF, VSB) sont reliées à l'espace avant ou à l'espace arrière au niveau de la première paroi (112_1), et sont disposées entre la première paroi (112_1) et l'élément de support avant (106);
dans lequel une deuxième vanne avant (VSF) et une deuxième vanne arrière (VSB) de la pluralité de vannes (VFF, VFB, VSF, VSB) sont reliées à l'espace avant ou à l'espace arrière au niveau de la deuxième paroi (112_2), et sont disposées entre la deuxième paroi (112_2) et l'élément de support arrière (108);
dans lequel la pluralité d'actionneurs (122, 1522) sont montés sur la pluralité d'unités de membrane (MU), de sorte que la pluralité d'unités de membrane (MU) effectue de manière flexible la déformation horizontale.

2. Elément de génération d'impulsion d'air (10, 1500, 1600) selon la revendication 1, dans lequel la première vanne avant (VFF) est commandée par un premier signal de commande de vanne avant pour commander un écoulement d'air à travers la plaque frontale avant (102); la première vanne arrière (VFB), commandée par un premier signal de commande de vanne arrière pour commander l'écoulement d'air à travers la plaque frontale arrière (104); la deuxième vanne avant (VSF), commandée par un deuxième signal de commande de vanne avant pour commander lécoulement d'air à travers la plaque frontale avant (102); et la deuxième vanne arrière (VSB), commandée par un deuxième signal de commande de vanne arrière pour commander l'écoulement d'air à travers la plaque frontale arrière (104).

3. Elément de génération d'impulsion d'air (10, 1500, 1600) selon la revendication 2, dans lequel le premier signal de commande de vanne avant est égal au deuxième signal de commande de vanne arrière, et le premier signal de commande de vanne arrière est égal au deuxième signal de commande de vanne avant.

4. Elément de génération d'impulsion d'air (10, 1500, 1600) de la revendication 1, dans lequel la pluralité d'actionneurs (122, 1522) sont des actionneurs électrostatiques avec une pluralité d'électrodes, de sorte que la pluralité d'unités de membrane (MU) effectue la déformation horizontale lorsqu'une pluralité de charges d'entraînement sont appliquées sur la pluralité d'électrodes.

5. Elément de génération d'impulsion d'air (10, 1500, 1600) de la revendication 1, dans lequel lorsque la pluralité d'actionneurs (122, 1522) sont des actionneurs piézoélectriques avec une pluralité d'électrodes, de sorte que la pluralité d'unités de membrane (MU) effectue la déformation horizontale lorsqu'une pluralité de charges d'entraînement sont appliquées sur la pluralité d'électrodes.

6. Elément de génération d'impulsion d'air (10, 1500, 1600) selon la revendication 1, dans lequel lorsque la membrane pliée (110, 1510, 1610) est incorporée avec un actionneur électromagnétique et un courant circule le long de la membrane pliée (110, 1510, 1610), de sorte que la pluralité d'unités de membrane (MU) effectue la déformation horizontale.

7. Elément de génération d'impulsion d'air (10, 1500, 1600) de la revendication 1, dans lequel l'élément de génération d'impulsion d'air (10, 1500, 1600) est configuré pour recevoir un signal audio d'entrée, et une amplitude et une polarité de chaque impulsion d'air générée par l'élément de génération d'impulsion d'air (10, 1500, 1600) sont liées à une amplitude et une polarité d'un échantillon de temps du signal audio d'entrée.

8. Elément de génération d'impulsion d'air (10, 1500, 1600) de la revendication 1, dans lequel une tension de commande est appliquée à chacun de la pluralité d'actionneurs (122, 1522) de l'élément de génération d'impulsion d'air (10, 1500, 1600), de sorte que l'élément de génération d'impulsion d'air (10, 1500, 1600) génère une pluralité d'impulsions d'air en réponse à la tension de commande; une pluralité d'impulsions d'air sont à une fréquence d'impulsion, et la fréquence d'impulsion de la pluralité d'impulsions d'air est supérieure à une fréquence audible maximale.

9. Elément de génération d'impulsion d'air (10, 1500, 1600) de la revendication 8, dans lequel la fréquence d'impulsion de la pluralité d'impulsions d'air est au moins deux fois supérieure à une fréquence maximale d'un signal audio d'entrée à reproduire.

10. Elément de génération d'impulsion d'air (10, 1500, 1600) de la revendication 8, dans lequel le taux d'impulsion de la pluralité d'impulsions d'air est au moins deux fois plus élevé qu'une fréquence audible maximale.

11. Elément de génération d'impulsion d'air (10, 1500, 1600) selon la revendication 1, dans lequel une direction d'une vitesse de masse d'air à l'intérieur d'un cycle d'impulsions est dans une direction avant-arrière ou une direction arrière-avant indépendamment d'une position initiale de la membrane pliée (110, 1510, 1610), et une pluralité de signaux de commande de vanne sont générés vers la pluralité de vannes (VFF, VFB, VSF, VSB) pour effectuer un mouvement d'ouverture et de fermeture.

12. Elément de génération d'impulsion d'air (10, 1500, 1600) de la revendication 11, dans lequel la déformation horizontale effectuée par la pluralité d'unités de membrane (MU) et le mouvement d'ouverture et de fermeture effectué par la pluralité de vannes (VFF, VFB, VSF, VSB) sont mutuellement synchronisés.

13. Procédé de fabrication (1700) de la membrane pliée (110, 1510, 1610) de l'élément de génération d'impulsion d'air (10, 1500, 1600) de la revendication 1, comprenant:
déposer un substrat (1704);
réaliser une gravure par ions réactifs, qui est RIE, ou une gravure par ions réactifs en profondeur, qui est DRIE, sur le substrat avec un motif plié (1706);
déposer une première couche diélectrique sur le substrat (1710);
déposer une couche conductrice sur la première couche diélectrique (1712);
déposer une deuxième couche diélectrique sur la couche conductrice (1714); et
graver le substrat pour former la membrane pliée (1716).

14. Procédé de fabrication de la revendication 13, comprenant en outre:
déposer une couche sacrificielle avant déposer la première couche diélectrique sur le substrat (1708).

15. Procédé de fabrication de la revendication 14, comprenant en outre:
graver la couche sacrificielle après déposer la deuxième couche diélectrique sur la couche conductrice.

16. Procédé de fabrication (2100) de la membrane pliée (110, 1510, 1610) de l'élément de génération d'impulsion d'air (10, 1500, 1600) de la revendication 1, comprenant:
former une pluralité de tranchées sur un substrat à motifs (2104);
réaliser une gravure isotrope pour découper un fond de la pluralité de tranchées et former une pluralité d'unités de connexion (2106);
revêtir la pluralité de tranchées avec un film polymère (2108); et
retirer le substrat à motifs pour former la membrane pliée (2110).
